# EUROPEAN PATENT APPLICATION

(11) **EP 2 325 910 A1**
(43) Date of publication of application: **25.05.2011**
(21) Application number: 09176927.3
(22) Date of filing: 24.11.2009
(51) Int. Cl.: H01L 41/09, H01L 41/22, B81B 3/00

(54) **MEMS device and method of fabrication**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

A MEMS device, and method of fabrication thereof, comprising: a wall arranged as a closed loop (for example, comprising a plurality of interconnected lengths (11-18)); and a bridging portion (54) having two ends and an intermediate portion between these ends; the bridging portion (54) is connected at one end to a first portion of the wall and at the other end to a second portion of the wall non-contiguous to the first; whereby when the intermediate portion is displaced in a direction through a plane defined between the two ends, the portions of the wall connected to the bridging portion (54) are each displaced in a respective direction in the plane, and at least one further portion of the wall is displaced in a direction that is in the plane and that is different to the directions that the two portions connected to the bridging portion (54) are displaced in.

## Description

### FIELD OF THE INVENTION

The present invention relates to Micro Electro Mechanical System (MEMS) devices and the fabrication thereof.

### BACKGROUND

Micro Electro Mechanical System (MEMS) devices are known. One type of known MEMS device is an MEMS actuator in which an electric field is applied across a piezoelectric material to produce a small strain, which is used to actuate the device. Such devices have a wide range of potential applications, for example, actuators in aircraft, or accelerometers.

Typical manufacturing requirements for MEMS actuators include small size, mass-producibility, high reliability and good energy efficiency.

There is a general need for MEMS devices that provide actuation movement within the plane of their manufacture, i.e. within the plane of the layers of material that the MEMS device is formed from, whilst maintaining the aforementioned requirements. Conventionally, this need is met by MEMS devices that provide actuation out of the plane of the components being manufactured and then removed and reconnected such that the actuation is in the required direction. However, this process tends to be costly, time-consuming, and lacks manufacturing flexibility, e.g. with regard to interconnecting groups of devices with each other and/or with other elements such as drive electronics.

### SUMMARY OF THE INVENTION

In a first aspect the present invention provides a MEMS device comprising: a wall arranged as a closed loop; and a bridging portion; wherein the bridging portion has two ends and an intermediate portion between the two ends; and the bridging portion is connected at one end to a first portion of the wall and at the other end to a second portion of the wall, the first and second portions of the wall being non-contiguous; whereby when the intermediate portion of the bridging portion is displaced in a direction through a plane defined between the two ends, the two portions of the wall that are connected to the bridging portion are each displaced in a respective direction in the plane defined between the two ends, and thereby at least one further portion of the wall is displaced in a direction that is in the plane defined between the two ends and that is different to the directions that the two portions of the wall that are connected to the bridging portion are displaced in.

The wall may comprise a plurality of interconnected lengths; and the bridging portion may be connected at one end to a first of the lengths of the wall and at the other end to a second of the lengths of the wall, the first and second lengths of the wall being non-contiguous; whereby when the intermediate portion is displaced in a direction through a plane defined between the two lengths of the wall, the two lengths of the wall connected to the bridging portion are each displaced in a respective direction in the plane defined between the two ends, and thereby at least one further length of the wall is displaced in a direction that is in the plane defined between the two ends and that is different to the directions that the two lengths of the wall connected to the bridging portion are displaced in.

Before the displacement of the intermediate portion, the intermediate portion may be substantially in the plane defined between the two ends.

The lengths of the wall may each be substantially perpendicular to the plane defined between the two ends.

The distance that the at least one further length of the wall is displaced may be different to the distance that the two lengths of the wall connected to the bridging portion are each displaced.

The distance that the at least one further length of the wall is displaced may be larger than the distance that the two lengths of the wall connected to the bridging portion are each displaced.

The MEMS device may further comprise a flexure between at least one pair of contiguous lengths of the wall.

The bridging portion may divide the closed loop of interconnected lengths of the wall into a first group of interconnected lengths of the wall and a second group of interconnected lengths of the wall different to the first group; a first further length of the wall is a length in the first group; and a second further length of the wall is a length in the second group; whereby when the intermediate portion is displaced the first and second further lengths of the wall are displaced in respective different directions that are in the plane defined between the two ends and that are different to the directions that the two lengths of the wall connected to the bridging portion are displaced in.

The MEMS device may be formed from a single material.

In a further aspect, the present invention provides a MEMS device assembly, comprising a plurality of MEMS devices according to the above aspect.

In a further aspect, the present invention provides a method of manufacturing a MEMS device, the MEMS device according to any of the above aspects, and the method comprising etching a substrate to form the wall and the bridging portion.

In a further aspect, the present invention provides a method of operating a MEMS device flextension structure, the method comprising: displacing an intermediate portion of a bridging portion of the flextension structure in a direction through a plane defined between two ends of the bridging portion; such that at least two portions of the flextension structure connected to the bridging portion are each displaced in a respective direction in the plane defined between the two ends; and at least one further portion of the flextension structure is displaced in a direction that is in the plane defined between the two ends, and that is different to the directions that the at least two portions connected to the bridging portion are displaced in.

The distance that the at least one further portion is displaced may be different to the distance that the two portions connected to the bridging portion are each displaced.

The distance that the at least one further portion is displaced may be larger than the distance that the two portions connected to the bridging portion are each displaced.

The method may further comprise displacing a first and second further portions of the flextension structure in respective different directions that are in the plane defined between the two ends and that are different to the directions that the two portions of the flextension structure connected to the bridging portion are displaced in; wherein: the bridging portion divides a closed loop of the flextension structure into a first part and a second part different to the first part; the first part comprises the first further portion; and the second part comprises the second further portion.

### BRIEF DESCRIPTION OF THE DRAWINGS

Figure 1 is a process flowchart showing certain process steps carried out in an embodiment of a fabrication process for fabricating a MEMS device;
Figure 2 is a schematic illustration of a perspective view of a substrate;
Figure 3A is a schematic illustration of a perspective view of the substrate after shaping;
Figure 3B is a schematic illustration of a cross section of the substrate at step s4 of the fabrication process;
Figure 4A is a schematic illustration of a perspective view of the substrate after performing steps s2-s6 of the fabrication process;
Figure 4B is a schematic illustration of a cross section of the substrate at step s6 of the fabrication process;
Figure 5A is a schematic illustration of a perspective view of the substrate after performing steps s2-s8 of the fabrication process;
Figure 5B is a schematic illustration of a cross section of the substrate at step s8 of the fabrication process;
Figure 6 is a schematic illustration of the MEMS device formed by performing the fabrication process;
Figure 7 is a schematic illustration of the MEMS device after having undergone an example operation;
Figure 8 is a schematic illustration of a perspective view of a further MEMS device comprising flexures;
Figure 9 is a schematic illustration of a perspective view of a further MEMS device;
Figure 10 is a schematic illustration of a perspective view of a further MEMS device fabricated such that the bridging portion bends upwards when in a resting position; and
Figure 11 is an exploded schematic illustration of two MEMS devices coupled together to form a coupled MEMS device.

### DETAILED DESCRIPTION

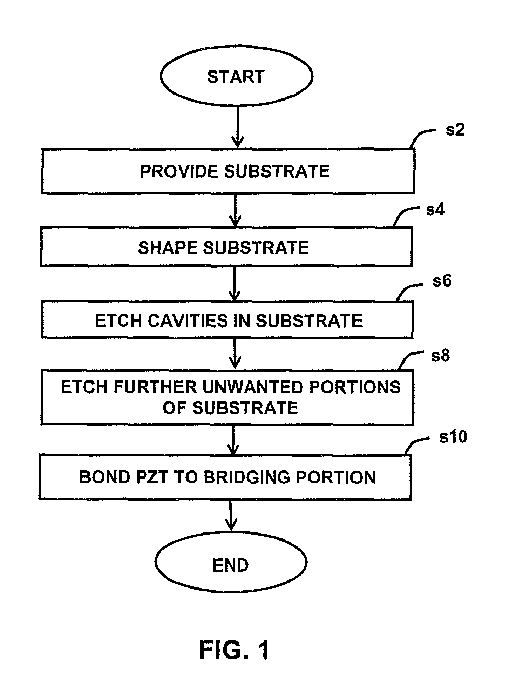

Figure 1 is a process flowchart showing certain process steps carried out in an embodiment of a fabrication process for fabricating a MEMS device. Terminology used in the description of the process that describes relative positions of features of the MEMS device, such as "the top", "the bottom" etc. is used in a merely relative sense for ease of reference and is non-limiting.

At step s2, a section of a substrate material, hereinafter referred to as "the substrate 2", is provided. In this embodiment the substrate 2 is silicon.

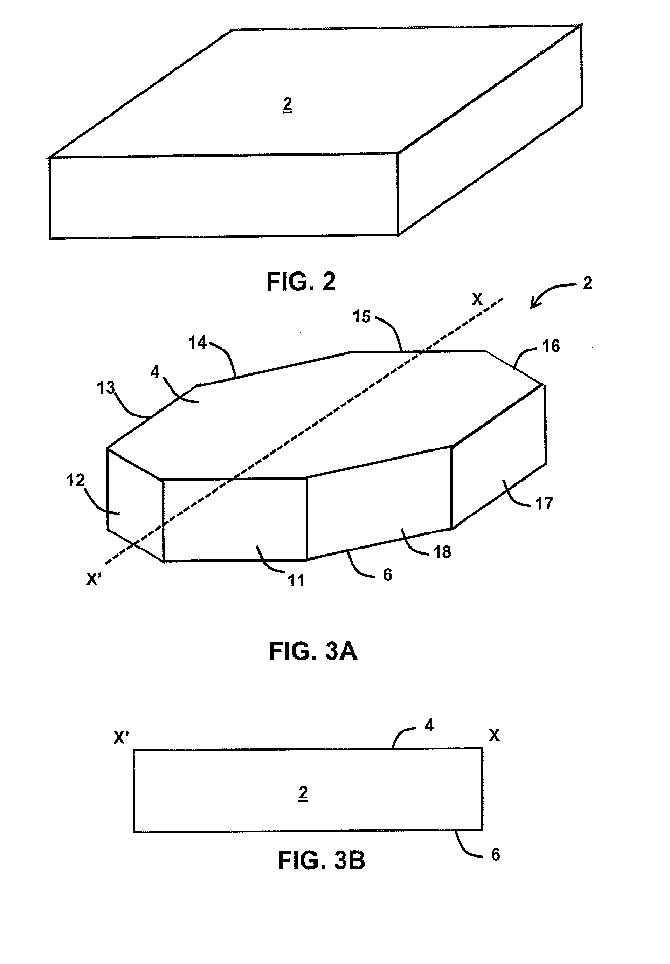

Figure 2 is a schematic illustration (not to scale) of a perspective view of the substrate 2.

At step s4, the substrate 2 is shaped. In this embodiment the substrate 2 is shaped such that it is substantially an octagonal prism.

Figure 3A is a schematic illustration (not to scale) of a perspective view of the shaped substrate 2. The shaped substrate 2 has a top surface 4, a bottom surface 6, a first side 11, a second side 12, a third side 13, a fourth side 14, a fifth side 15, a sixth side 16, a seventh side 17, and an eighth side 18. The top surface 4 is an octagonal surface having eight edges, each of which is connected to a respective one of the eight sides 11-18. The bottom surface 6 is an octagonal surface opposite the top surface 4. The bottom surface 6 has eight edges, each of which is contiguous with a respective one of the eight sides 11-18. Each of the eight sides 11-18 of the substrate 2 is orthogonal to the top surface 4 and the bottom surface 6.

The first side 11 is contiguous with the second side 12 and the eighth side 18. The second side 12 is contiguous with the first side 11 and the third side 13. The third side 13 is contiguous with the second side 12 and the fourth side 14. The fourth side 14 is contiguous with the third side 13 and the fifth side 15. The fifth side 15 is contiguous with the fourth side 14 and the sixth side 16. The sixth side 16 is contiguous with the fifth side 15 and the seventh side 17. The seventh side 17 is contiguous with the sixth side 16 and the eighth side 18. The eighth side 18 is contiguous with the seventh side 17 and the first side 11.

Figure 3B is a schematic illustration (not to scale) of a cross section of the substrate 2 at step s4 taken through the line X-X' (indicated by a dotted line in Figure 3A). The cross section X-X' of the substrate 2 at step s4 is substantially rectangular.

At step s6, two cavities are etched in to the top surface 4 of the substrate 2.

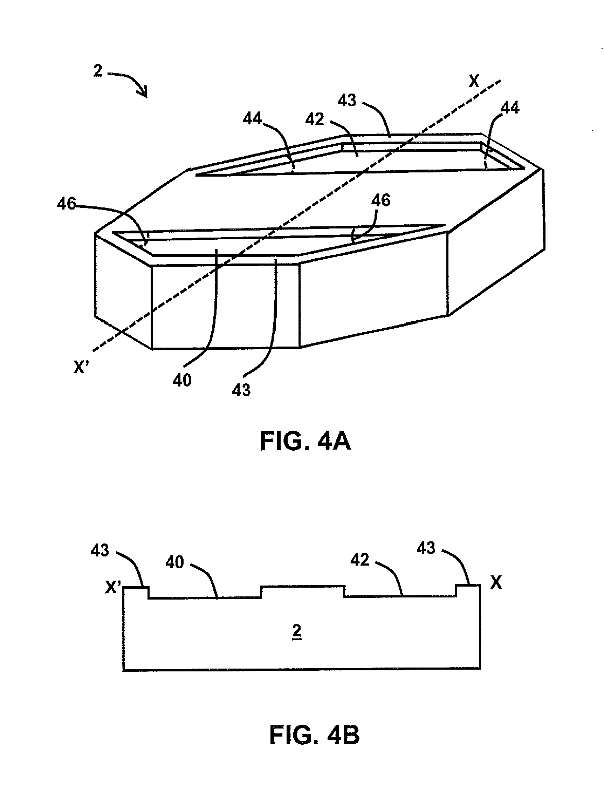

Figure 4A is a schematic illustration (not to scale) of a perspective view of the substrate 2 after performing steps s2-s6 of the fabrication process.

A first cavity 40 and a second cavity 42 are formed in the top surface 4. The first and second cavities 40, 42 are substantially trapezium in shape. The first and second cavities 40, 42 are each formed by a process of deep reactive-ion etching (DRIE). In this DRIE process, portions of the top surface 4 of the substrate 2 that are not to be etched at step s6 are covered by a protective layer. After the DRIE process is complete, i.e. after the first cavity 40 and the second cavity 42 are formed, this protective layer is removed.

The first cavity 40 and the second cavity 42 are positioned such that they lie on opposite portions of the top surface, and such that they are separated by an unetched strip between the third side 13 and the seventh side 17.

The edge of the first cavity 40 adjacent to the unetched strip between the third side 13 and the seventh side 17 joins certain other edges of the first cavity 40. In this embodiment, the angle that these edges join the edge of the first cavity 40 adjacent to the unetched strip, indicated in Figure 4A by dotted arcs and the reference numeral 44, is approximately five degrees.

The edge of the second cavity 42 adjacent to the unetched strip between the third side 13 and the seventh side 17 joins certain other edges of the second cavity 42. In this embodiment, the angle that these edges join the edge of the second cavity 42 adjacent to the unetched strip, indicated in Figure 4A by dotted arcs and the reference numeral 46, is five degrees.

Having values of five degrees for the angles 44, 46 tends to advantageously provide an improved range of motion, as described in more detail later below.

The first cavity 40 is positioned such that a first edge of the first cavity 40 is parallel to the edge of the top surface 4 corresponding to the first side 11, a second edge of the first cavity 40 is parallel to the edge of the top surface 4 corresponding to the second side 12, a third edge of the first cavity 40 is parallel to the edge of the top surface 4 corresponding to the first side 11, and a fourth edge of the first cavity 40 is parallel to the edge of the top surface 4 corresponding to the eighth side 18. The first cavity 40 is separated from the edges of the top surface 4 by an unetched rim 43.

The second cavity 42 is positioned such that a first edge of the second cavity 42 is parallel to the edge of the top surface 4 corresponding to the fifth side 15, a second edge of the second cavity 42 is parallel to the edge of the top surface 4 corresponding to the sixth side 16, a third edge of the second cavity 42 is parallel to the edge of the top surface 4 corresponding to the fifth side 15, and a fourth edge of the second cavity 42 is parallel to the edge of the top surface 4 corresponding to the fourth side 14. The second cavity 42 is separated from the edges of the top surface 4 by an unetched rim 43.

Figure 4B is a schematic illustration (not to scale) of a cross section of the substrate 2 at step s6 taken through the line X-X' (indicated by a dotted line in Figure 4A).

At step s8, the substrate 2 is etched further to remove unwanted portions of the substrate 2.

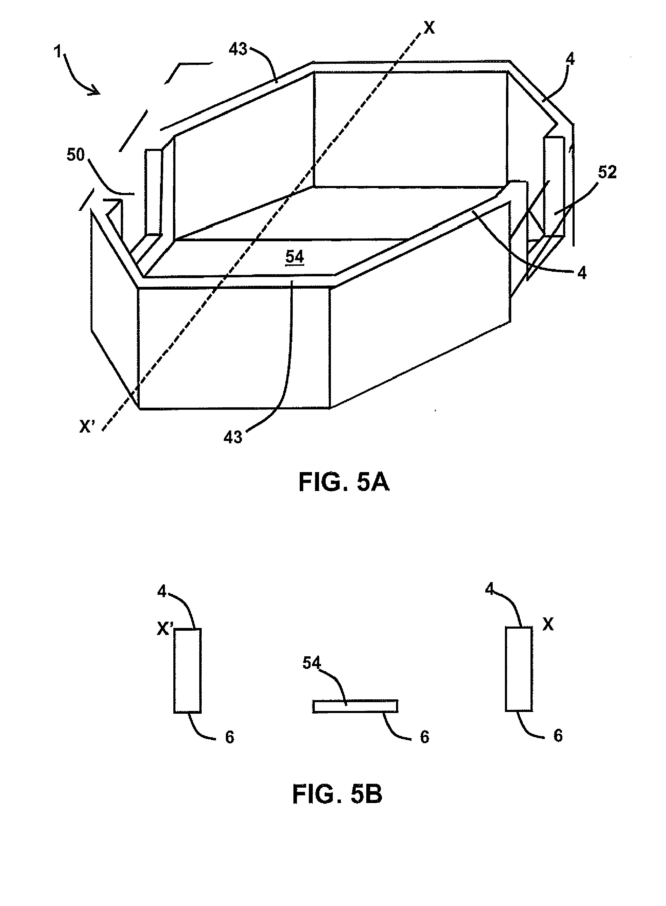

Figure 5A is a schematic illustration (not to scale) of a perspective view of the substrate 2 after performing steps s2-s8 of the fabrication process. The device resulting from performing steps s2-s8 is the MEMS device 1.

In this embodiment, the top surface 4 of the substrate 2 is removed using a process of deep reactive-ion etching (DRIE). In this DRIE process, portions of the top surface 4 of the substrate 2 that are not to be etched at step s8 are covered by a protective layer.

The portions of the top surface covered by the protective layer at step s8 are as follows: the unetched rim 43 surrounding a portion of the first cavity 40 and adjacent to the first side 11, the second side 12 and the eighth side 18; the unetched rim 43 surrounding a portion of the first cavity 40 and adjacent to the fourth side 14, the fifth side 15 and the sixth side 16; and portions of the substrate adjacent to the third side 13 and the seventh side 17 such that a portion of the substrate central to the third and seventh sides is removed. The substrate 2 is etched from the top surface 4 downwards towards the bottom surface 6 until the first cavity 40 and the second cavity 42 are etched through the bottom surface 6 of the substrate 2.

After the DRIE process of step s8 is complete this protective layer is removed.

Thus, the majority of the material in the central portion of the substrate 2 is removed. The unetched rim 43 along the first side 11, second side 12, third side 13, fourth side 14, fifth side 15, sixth side 16, seventh side 17, and eighth side 18 forms a wall of substrate material around the outer edge of the device. Equivalently, the sides 11 - 18 form lengths of an unetched wall at the edge of the device. These lengths of wall are arranged in a closed loop, i.e. the wall is a closed loop.

A first channel 50 is formed through the third side 13 of the substrate into this central void. A second channel 52 is formed through the seventh side 17 of the substrate into the central void. Also, a portion of substrate material of the bottom surface 6, hereinafter referred to as the "bridging portion 54", remains such that the edge of the bottom surface 6 corresponding to the third side 13 and the edge of the bottom surface 6 corresponding to the seventh side 17 are joined, or bridged, by the bridging portion 54.

Figure 5B is a schematic illustration (not to scale) of a cross section of the substrate 2 at step s8, i.e. a cross section of the MEMS device 1, taken through the line X-X' (indicated by a dotted line in Figure 5A).

At step s10, a layer of lead zirconate titanate (PZT), hereinafter referred to as "the PZT layer 55" is bonded to the part of the bridging portion 54 that forms the bottom surface 6 of the substrate 2.

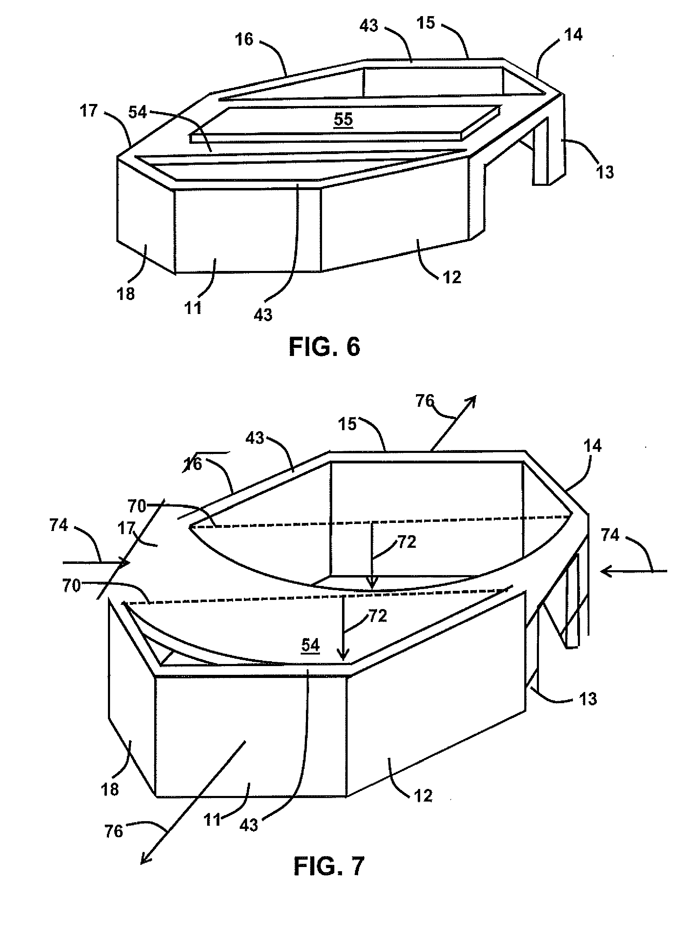

Figure 6 is a further schematic illustration (not to scale) of the MEMS device 1 formed by performing the above described steps of the fabrication process for fabricating a MEMS device. The schematic illustration of Figure 6 is an upside-down view of the MEMS device 1 with respect to Figure 5A.

Thus, a process of fabrication of the MEMS device 1 is provided. The process of fabrication is planar, i.e. the process is applied to a plane, or layer, of material. In this embodiment, the MEMS device 1 is built from a single layer of the substrate 2. The MEMS device 1 is a flextension MEMS device, i.e. the device comprise a flexible member (the bridging portion 54), movement of which causes the device 1 to expand in a certain direction, as described below by means of an example operation of the MEMS device 1, with reference to Figure 7.

Figure 7 is a schematic illustration (not to scale) of the MEMS device 1, in the same orientation as Figure 6, after having undergone an example operation.

In this embodiment, the example operation is the movement of the bridging portion 54 downwards, from an original position (indicated by the dotted lines 70 in Figure 7) to a new position (shown in Figure 7). The downwards movement of the bridging portion 54 results from the application of a downwards force to the bridging portion 54. This downwards movement of the bridging portion 54 is in a direction that passes through what may be termed the plane of the MEMS device 1 (as opposed to in the plane, or parallel to the plane, of the MEMS device 1) i.e. the direction of the movement of the bridging portion 54 is from one side of the plane of the MEMS device 1 to the other side of the plane of the MEMS device 1. In other words, the direction of displacement of the bridging portion 54 passes through the plane of the substrate 2 layer. Such a through-plane direction of movement is typical in conventional MEMS devices. Embodiments of the present invention additionally achieve a direction of movement that may be termed as an in-plane direction of movement. Such in-plane directions of movement are in effect along, or parallel to, or in some other way within, the plane, rather than through the plane, i.e. in-plane direction of movement is in contrast to through-plane direction of movement.

In this embodiment, the downward force is applied by deforming the PZT layer 55 bonded to the bridging portion 54, by applying an electric field across the PZT layer 55. The applied electric field contracts the PZT layer 55 in the directions indicated in Figure 7 by arrows 74. This forces the third side 13 and the seventh side 17 of the MEMS device 1 to move closer together. Since the bridging portion 54 of the MEMS device 1 is of fixed length, the bridging portion 54 bends to accommodate for the closer relative positions of the third and seventh sides.

In this example, the central part of the bridging portion 54 is moved vertically downward by a certain specific distance, indicated by arrows 72 in Figure 7. The bridging portion 54 is supported at each end, i.e. along the third side 13 and the seventh side 17 of the MEMS device 1. Thus, the downward movement of the central part of bridging portion 54 causes the bridging portion 54 to be bent in to a "U-shape". During this operation, the absolute length of the bridging portion 54 is substantially constant. Thus, the bending of the bridging portion 54 causes the width of the MEMS device 1, i.e. the distance between the third side 13 and the seventh side 17 of the MEMS device 1, to be reduced. In other words, during the example operation of the MEMS device 1, the third side 13 and the seventh side 17 move closer together. This is indicated by arrows 74 in Figure 7.

During operation, the lengths of the sides 11-17 of the MEMS device 1 are substantially constant, i.e. the perimeter of the MEMS device 1 is substantially constant.

During operation, the reduction in the distance between the third side 13 and the seventh side 17 of the MEMS device 1 causes the distance between the portions of the fourth side 14 and the sixth side 16 that join the third side 13 and the seventh side respectively to be reduced. Since the fourth side 14 and the sixth side 16 are joined to the fifth side 15, and the length of these sides 14, 15, 16 are substantially constant during operation, the angle between the fourth side 14 and the bridging portion 54, and the angle between the sixth side 16 and the bridging portion 54 (i.e. the angles 44 indicated by dotted arcs in Figure 4A), are increased by an amount proportional to the specific distance 72 that the bridging portion is moved. Thus, the fifth side 15 moves away from the bridging portion 54.

Also during operation, the reduction in the distance between the third side 13 and the seventh side 17 of the MEMS device 1 causes the distance between the portions of the second side 12 and the eighth side 18 that join the third side 13 and the seventh side respectively to be reduced. Since the second side 12 and the eighth side 18 are joined to the first side 11, and the length of these sides 11, 12, 18 are substantially constant during operation, the angle between the second side 12 and the bridging portion 54, and the angle between the eighth side 18 and the bridging portion 54 (i.e. the angles 44 indicated by dotted arcs in Figure 4A), are increased by an amount proportional to the specific distance 72 that the bridging portion is moved. Thus, the first side 11 moves away from the bridging portion 54.

In other words, during the example operation of the MEMS device 1, the first side 11 and the fifth side 15 move apart. This is indicated by arrows 76 in Figure 7.

The movement of the first and fifth sides 11, 15 of the MEMS device 1 that occurs during operation is in the plane of the MEMs device, i.e. the first and fifth sides 11, 15 move in the plane of the substrate 2. This movement within the plane of the MEMS device 1 is driven by the movement of the bridging portion 54 of the MEMS device 1 in a direction substantially perpendicular to the plane of the MEMS device 1.

An advantage provided by the MEMS device 1, i.e. a MEMS device capable of moving within the plane in which it is fabricated, is that systems comprising different components, for example MEMS devices that implement movement both in the plane of fabrication and out of the plane of fabrication, can be produced on, or from, a single substrate wafer. This advantageously provides that the requirements to individually connect separate components tend to be reduced. Thus, cost and time savings tend to result. For example, this allows mass production of devices in a continuous process flow.

A further advantage is provided by the angles 44, 46 having relatively small values (in this embodiment the values of the angles 44, 46 are approximately five degrees). Use of an angle of approximately five degree advantageously provides that, during operation, the distance that the first side 11 and the fifth side 15 move apart (as indicated by arrows 76 in Figure 7) tends to be larger than the distance that the third side 13 and the seventh side 17 move together. In other words, a small movement together of the third and seventh sides is translated into a larger movement apart of the first and fifth sides.

In other embodiments one or more of the angles 44, 46 has a different appropriate value. For example, one or more of the angles may have a value between 0.1 degree and ten degrees. The chosen values of the angles 44, 46 determine the displacement of the first and fifth sides for a given displacement of the bridging portion 54, or force applied to the bridging portion 54. This advantageously tends to provide that different flextension MEMS devices, having different angle sizes, can be fabricated to fulfil different engineering requirements. In other words, the appropriate values for the angles 44, 46 can be chosen to provide appropriate displacement amplification factors between the displacement of the bridging portion 54 and the displacement apart of the first and fifth sides 11, 15.

In the above embodiments, the substrate is silicon. However, in other embodiments the substrate is a different appropriate material.

In the above embodiments, the first and second cavities are trapezia. However, in other embodiments the first and/or the second cavities are different appropriate shape.

In the above embodiments, the MEMS device is made by etching a first cavity and a second cavity, and then etching these cavities through the body of the substrate. However, in other embodiments the MEMS device is made by etching any number of appropriately shaped cavities, and then etching these cavities through the body of the substrate, so as to provide the same functionality as that provide above, i.e. movement of the MEMS device within the plane of the MEMS device.

In the above embodiments, at steps s6 and s8, unnecessary portions of the substrate are etched away using a process of deep reactive-ion etching (DRIE). However, in other embodiments one or more different appropriate processes are used to remove unnecessary portions of the substrate. In other embodiments, a DRIE process and one or more different appropriate processes are used to remove unnecessary portions of the substrate.

In the above embodiments, the MEMS device has a bridging portion between the third and seventh sides of the MEMS device. However, in other embodiments, the MEMS device has a bridging portion between different appropriate sides of the MEMS device. Also, in other embodiments the MEMS device has more than one bridging portion between more than one pairs of sides of the MEMS device such that the same functionality of the MEMS device is provided.

In the above embodiments, an operation of the MEMS device is described using a downward movement of the central portion of the bridging portion through a certain specific distance. However, in other embodiment, an operation of the MEMS device is implemented using a different appropriate movement of the bridging portion of the MEMS device, for example an upwards movement of the central portion of the bridging portion of the MEMS device through a certain specific distance.

In the above embodiments, the steps of the fabrication process of the MEMS device are carried out sequentially, as described above with reference to Figure 1. However, in other embodiments, the same or different steps are carried out in a same or different order such that a MEMS device having the same functionality as that described above is provided.

In the above embodiments, unnecessary portions of the substrate are etched away at steps s6 and s8, as described above. However, in other embodiments, in addition to these unnecessary portions of the substrate, further portions of the substrate are etched away to provide notches, or flexures, at one or more vertices of the first and/or second cavities.

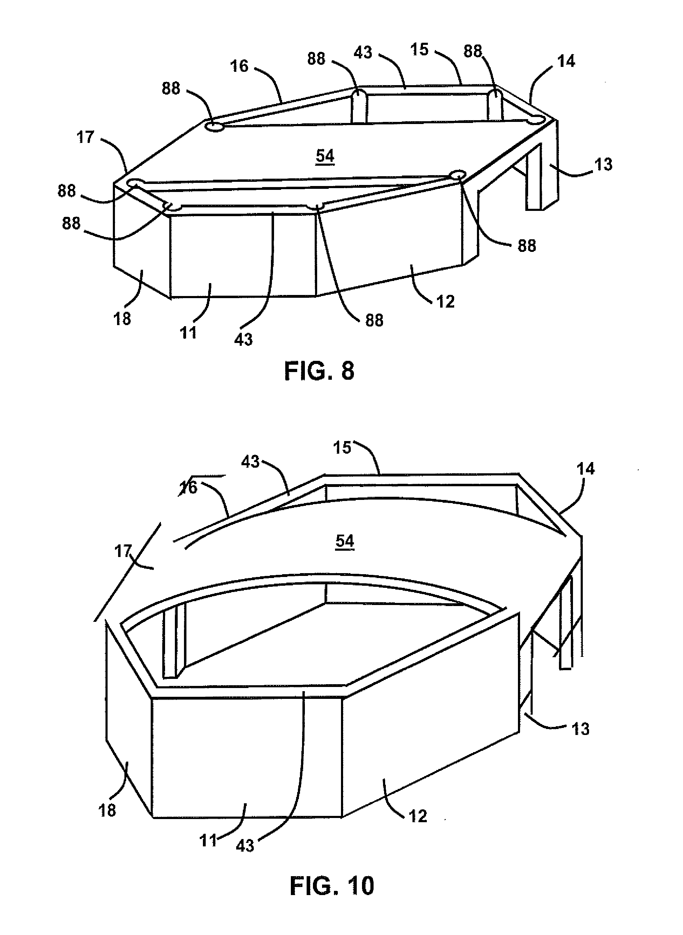

Figure 8 is a schematic illustration (not to scale) of a perspective view of a second MEMS device fabricated using a second embodiment of the fabrication process. In this embodiment, additional portions of substrate removed at the vertices of the voids in the substrate 2 corresponding to the first and second cavities 40, 42 to form flexures 88, i.e. areas of the unetched rim 43 where the thickness of the substrate 2 is reduced to facilitate easier bending at certain points. In Figure 8, those features in common with the MEMS device described in the first embodiment are indicated by the same reference numerals. An advantage provided by the flexures 88 is that the flexibility of the MEMS device 1 tends to be improved. This tends to reduce the force required to displace the bridging portion 54 of the MEMS device 1. Thus, the force required to provide movement of the MEMS device 1 in the plane of the MEMS device is reduced.

In the above embodiments, at step s4 the substrate is shaped such that it is substantially an octagonal prism. However, in other embodiments the substrate is shaped such that it is a different appropriate shape. Other possible shapes include, for example, bows or curves.

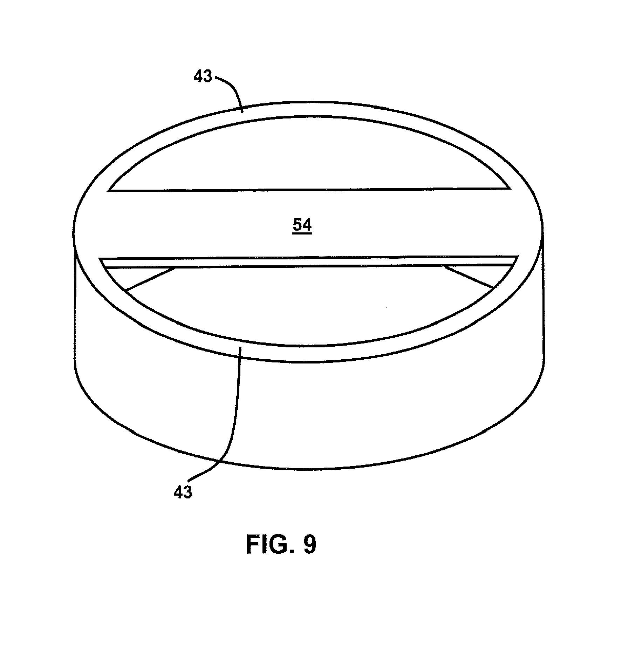

Figure 9 is a schematic illustration (not to scale) of a perspective view of a third MEMS device fabricated using a third embodiment of the fabrication process. In Figure 10, those features in common with the MEMS device described in the first embodiment are indicated by the same reference numerals. The MEMS device of this embodiment comprises a continuous curved wall. This continuous curved wall replaces the interlinked sides of the MEMS device of the first embodiment.

The flextension functionality of the MEMS device of the first embodiment is preserved by the continuous curved wall of the third MEMS device. As such, the third MEMS device represents an embodiment of the invention, and may be used where appropriate. Nevertheless, it does not have certain additional advantages that tend to be provided by the earlier described MEMS device of the first embodiment.

Additional advantages that tend to be provided by the earlier described MEMS device of the first embodiment include the following.

The first side 11 and the fifth side 15 of the MEMS device of the first embodiment are substantially flat. During operation, each point on one of these sides tends to be moved through the same distance in the same direction. Thus, it tends to be advantageously easy to determine the location of a device coupled to one of these sides. In contrast, during operation each point on a bowed or curved surface is moved in a different direction and/or by a different distance. Thus, it tends not to be as easy to determine the location of a device coupled to a curved side.

The sides of the MEMS device in the first embodiment tend to be able to be relatively rigid. The relative rigidity of these sides tends to reduce unwanted deformation of the sides whilst not adversely affecting the ability to move of the sides resulting from flextension. Nevertheless this ability to move may be improved by the addition of flexures, as described above with reference to Figure 8. However, the continuous curved wall of the third MEMS device is required to be sufficiently thin to provide for movement of the wall resulting from flextension. To provide for this movement, the curved wall tends to require a rigidity that is less than that of the sides of the MEMS device of the first embodiment. Thus, unwanted deformation of the sides tends not to be reduced.

In the above embodiments, the MEMS device is fabricated such that the position of the bridging portion when no force is applied, i.e. the "resting position" of the bridging portion, is substantially flat. However, in other embodiments the MEMS device may be fabricated such that the resting position of the bridging portion is not flat. For example, the MEMS device may be fabricated such that the bridging portion bends upwards when in a resting position. This is accomplished, for example, by fabricating the MEMS device using the fabrication process described above, with the substrate under tension.

Figure 10 is a schematic illustration (not to scale) of a perspective view of a fourth MEMS device fabricated using a fourth embodiment of the fabrication process. In Figure 10, those features in common with the MEMS device described in the first embodiment are indicated by the same reference numerals. In this embodiment the bridging portion 54 bends upwards when the device is in a resting position. Applying the same downwards force, as described above with reference to Figure 7, to the bridging portion 54 the MEMS device shown in Figure 10 tends to provide a motion in the plane of the MEMS device shown in Figure 10.

The application of a downwards force to the central portion of the bridging portion 54 of the fourth MEMS device (shown in Figure 10) provides that the bridging portion 54 is moved from a bent position to a substantially flat position. Thus, the third side 13 and the seventh side 17 of the fourth MEMS device are moved apart. For the above described reasons, this provides that the first side 11 and the fifth side 15 of the fourth MEMS device move closer together. In other words, the fourth MEMS device may, from its initial resting position, provide an inwards force relative to the fourth MEMS device. Alternatively, the application of an upwards force to the central portion of the bridging portion 54 of the fourth MEMS device (shown in Figure 10) provides that the bridging portion 54 is moved into a position in which it is bent to a greater degree. Thus, the third side 13 and the seventh side 17 of the fourth MEMS device are moved closer together. For the above described reasons, this provides that the first side 11 and the fifth side 15 of the fourth MEMS device move apart. In other words, the fourth MEMS device may, from its initial resting position, provide an outwards force relative to the fourth MEMS device.

Thus, an advantage provided by a MEMS device having a pre-bent bridging portion is that the MEMS device may produce either an inwards or outwards force, i.e. pulling or pushing force, from its initial, or resting position, depending on the direction of the force applied to the bridging portion 54.

A further mode of operation of the fourth MEMS device of Figure 10, is to apply a downwards force to the central portion of the bridging portion 54 of the MEMS device shown in Figure 10 such that the bridging portion 54 is bent into the following positions in turn: 'bending upwards'; 'substantially flat'; 'bending downwards'. This provides that, under the application of a force in a single direction, i.e. the downwards force applied to the central portion of the bridging portion 54, the first side 11 and the fifth side 15 of the MEMS device shown in Figure 10 are moved from a resting position, to being closer together, and back to substantially their resting position. Thus, the MEMS device shown in Figure 10 tends to advantageously provide a greater range of motion of the device, in the plane of the device, for a force in a given direction.

Also, in other embodiments, the PZT layer (or other suitable material or arrangement) may be attached to, or otherwise coupled to, the bridging portion in other ways rather than the particular way described for the above embodiments.

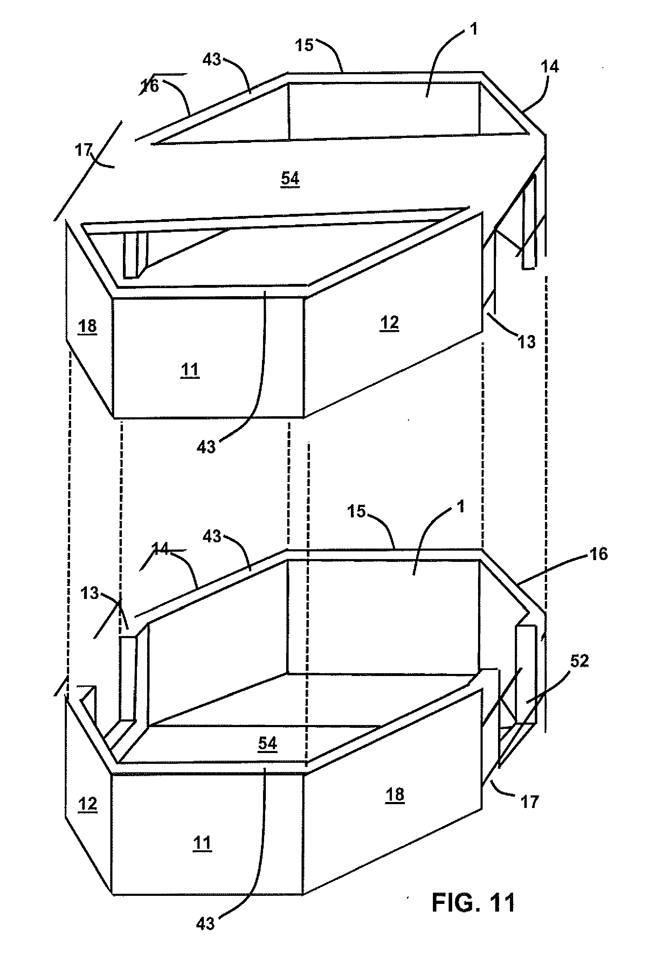

In the above embodiments, a single MEMS device provides movement in the plane of the MEMS device by application of a force substantially perpendicular to the plane of the MEMS device. However, in other embodiment one or more MEMS device may be coupled together. For example, Figure 11 is an exploded schematic illustration (not to scale) of two MEMS devices 1, fabricated using the process described above with reference to Figure 1, coupled together to form a coupled MEMS device 100. The MEMS devices 1 are coupled such that the bridging portions 54 of the respective MEMS devices are on the top and bottom surfaces of the coupled MEMS device 100. The coupled MEMS device advantageously provides that, under the application of appropriate forces to the bridging portions 54 of the two MEMS devices 1 that form the coupled MEMS device 100, the bending of the MEMS devices 1 in directions out of the plane of the MEMS device is reduced. The coupled MEMS device 100 tends to have increased stability. In other words, the applied appropriate forces to the bridging portions 54 of the two MEMS devices 1 is tends to be translated into movement of the coupled MEMS device 100 in the required direction, i.e. in the plane of the MEMS devices 1, with greater efficiency.

## Claims

1. A MEMS device comprising:
a wall arranged as a closed loop; and
a bridging portion (54); wherein
the bridging portion (54) has two ends and an intermediate portion between the two ends; and
the bridging portion (54) is connected at one end to a first portion of the wall and at the other end to a second portion of the wall, the first and second portions of the wall being non-contiguous; whereby
when the intermediate portion of the bridging portion (54) is displaced in a direction through a plane defined between the two ends, the two portions of the wall that are connected to the bridging portion (54) are each displaced in a respective direction in the plane defined between the two ends, and thereby at least one further portion of the wall is displaced in a direction that is in the plane defined between the two ends and that is different to the directions that the two portions of the wall that are connected to the bridging portion (54) are displaced in.

2. A MEMS device comprising according to claim 1, wherein:
the wall comprises a plurality of interconnected lengths (11-18); and
the bridging portion (54) is connected at one end to a first of the lengths (13) of the wall and at the other end to a second of the lengths (17) of the wall, the first and second lengths (13, 17) of the wall being non-contiguous; whereby
when the intermediate portion is displaced in a direction through a plane defined between the two lengths (13, 17) of the wall, the two lengths (13, 17) of the wall connected to the bridging portion (54) are each displaced in a respective direction in the plane defined between the two ends, and thereby at least one further length of the wall is displaced in a direction that is in the plane defined between the two ends and that is different to the directions that the two lengths (13, 17) of the wall connected to the bridging portion (54) are displaced in.

3. A MEMS device according to claim 2 wherein, before the displacement of the intermediate portion, the intermediate portion is substantially in the plane defined between the two ends.

4. A MEMS device according to claim 2 or 3, wherein the lengths (11-18) of the wall are each substantially perpendicular to the plane defined between the two ends.

5. A MEMS device according to any of claims 2 to 4, wherein the distance that the at least one further length of the wall is displaced is different to the distance that the two lengths (13, 17) of the wall connected to the bridging portion (54) are each displaced.

6. A MEMS device according to claim 5, wherein the distance that the at least one further length of the wall is displaced is larger than the distance that the two lengths (13, 17) of the wall connected to the bridging portion (54) are each displaced.

7. A MEMS device according to any of claims 2 to 6, further comprising a flexure (88) between at least one pair of contiguous lengths of the wall.

8. A MEMS device according to any of claims 2 to 6, wherein
the bridging portion (54) divides the closed loop of interconnected lengths (11-18) of the wall into a first group of interconnected lengths (18, 11, 12) of the wall and a second group of interconnected lengths (14, 15, 16) of the wall different to the first group;
a first further length of the wall is a length in the first group (18, 11, 12); and
a second further length of the wall is a length in the second group (14, 15, 16); whereby
when the intermediate portion is displaced the first and second further lengths of the wall are displaced in respective different directions that are in the plane defined between the two ends and that are different to the directions that the two lengths (13, 17) of the wall connected to the bridging portion (54) are displaced in.

9. A MEMS device according to any of claims 1 to 8, the MEMS device being formed from a single material.

10. A MEMS device assembly, comprising a plurality of MEMS devices according to any of claims 1 to 9 coupled together.

11. A method of manufacturing a MEMS device according to any of claims 1 to 9, the method comprising etching a substrate (2) to form the wall and the bridging portion (54).

12. A method of operating a MEMS device flextension structure, the method comprising:
displacing an intermediate portion of a bridging portion (54) of the flextension structure in a direction through a plane defined between two ends of the bridging portion (54); such that
at least two portions of the flextension structure connected to the bridging portion (54) are each displaced in a respective direction in the plane defined between the two ends; and
at least one further portion of the flextension structure is displaced in a direction that is in the plane defined between the two ends, and that is different to the directions that the at least two portions connected to the bridging portion (54) are displaced in.

13. A method according to claim 12, wherein the distance that the at least one further portion is displaced is different to the distance that the two portions connected to the bridging portion (54) are each displaced.

14. A method according to claim 12, wherein the distance that the at least one further portion is displaced is larger than the distance that the two portions connected to the bridging portion (54) are each displaced.

15. A method according to any of claims 12 to 14, further comprising displacing a first and second further portions of the flextension structure in respective different directions that are in the plane defined between the two ends and that are different to the directions that the two portions of the flextension structure connected to the bridging portion (54) are displaced in; wherein:
the bridging portion (54) divides a closed loop of the flextension structure into a first part and a second part different to the first part;
the first part comprises the first further portion; and
the second part comprises the second further portion.
